# EUROPEAN PATENT APPLICATION

(11) **EP 4 553 095 A1**
(43) Date of publication of application: **14.05.2025**
(21) Application number: 23835837.8
(22) Date of filing: 05.07.2023
(51) Int. Cl.: C08F 290/06, C08F 220/18, C08F 220/28, C08F 220/32, C08F 2/50, C08F 2/44, C08K 5/3432, C08K 5/527, F21K 9/00

(54) **RESIN COMPOSITION AND LIGHTING DEVICE COMPRISING SAME**

(30) Priority: 08.07.2022 KR 20220084569
(71) Applicant: LG INNOTEK CO. LTD, Gangseo-gu Seoul 07796 (KR)
(72) Inventor: KIM, Won Jin, Seoul 07796 (KR); KIM, Jin Young, Seoul 07796 (KR)
(74) Representative: Plasseraud IP
(86) International application number: PCT/KR2023/009521
(87) International publication number: WO 2024/010371

(57) **Abstract**

A resin composition according to an embodiment includes an oligomer, a monomer, a photoinitiator, and an additive, wherein the oligomer is contained in an amount of 10 wt% to 25 wt% based on a total weight of the resin composition, wherein the monomer is contained in an amount of 60 wt% to 70 wt% based on the total weight of the resin composition, wherein the photoinitiator is contained in an amount of 0.5 wt% to 1.2 wt% based on the total weight of the resin composition, wherein the additive includes a first additive comprising a radical removing agent and a second additive comprising a peroxide decomposition agent, wherein the photoinitiator includes phosphorus (P), wherein the second additive includes phosphorus (P), and wherein a weight % of the photoinitiator is greater than a weight % of each of the first additive and the second additive.

## Description

### [Technical Field]

The embodiment relates to a resin composition and a lighting device comprising the same.

### [Background Art]

Lighting applications include not only vehicle lighting but also backlights for displays and signboards.

A light emitting device, such as a light emitting diode (LED), has advantages such as low power consumption, semi-permanent lifespan, fast response speed, safety, and environmental friendliness compared to a conventional light source such as a fluorescent lamp and an incandescent lamp. The light emitting diode is applied to various lighting devices such as various display devices, indoor lights, and outdoor lights.

Recently, lamps (i.e. lighting devices) that use light emitting diodes as vehicle light sources have been proposed. Compared to incandescent lamps, light emitting diodes have the advantage of low power consumption. However, since an emission angle of light emitted from light emitting diodes is small, there is a demand to increase a light emitting area of lamps using light emitting diodes when using light emitting diodes as vehicle lamps.

Since the light emitting diodes are small in size, the light emitting diodes can increase the design freedom of the lamp and are also economical due to their semi-permanent lifespan.

On the other hand, since the lamps are applied to vehicles, heat may be generated above a set temperature during operation of the lamps. This heat can cause yellowing of an optical resin forming the lamp. This yellowing can reduce the reliability of the optical resin, and thereby, the reliability of the lamp can also be reduced.

Accordingly, a resin composition capable of solving the above problems and a lighting device including the same are required.

### [Disclosure]

### [Technical Problem]

The embodiment provides a resin composition having improved reliability by suppressing yellowing and a lighting device including the same.

### [Technical Solution]

A resin composition according to an embodiment comprises an oligomer, a monomer, a photoinitiator, and an additive, wherein the oligomer is contained in an amount of 10 wt% to 25 wt% based on a total weight of the resin composition, wherein the monomer is contained in an amount of 60 wt% to 70 wt% based on the total weight of the resin composition, wherein the photoinitiator is contained in an amount of 0.5 wt% to 1.2 wt% based on the total weight of the resin composition, wherein the additive includes a first additive comprising a radical removing agent and a second additive comprising a peroxide decomposition agent, wherein the photoinitiator includes phosphorus (P), wherein the second additive includes phosphorus (P), and wherein a weight % of the photoinitiator is greater than a weight % of each of the first additive and the second additive.

A resin composition according to an embodiment comprises an oligomer, a monomer, a photoinitiator, a first additive, and a second additive, wherein the oligomer is contained in an amount of 10 wt% to 25 wt% based on a total weight of the resin composition, wherein the monomer is contained in an amount of 60 wt% to 70 wt% based on the total weight of the resin composition, wherein the photoinitiator is contained in an amount of 0.5 wt% to 1.2 wt% based on the total weight of the resin composition, wherein a sum of a wt% of the first additive and a wt% of the second additive is contained in an amount of 0.5 wt% to 1.6 wt% based on the total weight of the resin composition, wherein the first additive includes a radical removing agent, wherein the second additive includes a peroxide decomposition agent, wherein the photoinitiator includes phosphorus (P), the second additive includes phosphorus (P), and wherein a ³¹P-NMR peak area of the second additive is 10% to 90% of a ³¹P-NMR peak area of the photoinitiator.

### [Advantageous Effects]

A resin composition according to the embodiment can improve reliability of a resin layer formed by curing a resin composition.

In detail, the photoinitiator of the resin composition can have a decomposition temperature within a set size range. Accordingly, the photoinitiator can have improved heat resistance. Accordingly, when a lighting device including the resin layer is applied to a vehicle or the like and operates, the photoinitiator can be reduced from being decomposed by heat generated. That is, the embodiment can prevent the photoinitiator from decomposing to form radicals. Accordingly, the embodiment can reduce yellowing of the resin layer.

In addition, the photoinitiator of the resin composition can absorb a wavelength within a set size range. Accordingly, the embodiment can minimize the photoinitiator from absorbing light in an infrared wavelength band. Accordingly, the embodiment can prevent the photoinitiator from absorbing blue light emitted from the light emitting device, thereby preventing a decrease in a brightness of the lighting device.

In addition, the resin composition can include an additive. Accordingly, yellowing of the resin layer can be reduced.

The resin composition according to the embodiment may include a first additive for removing radicals formed from the residual photoinitiator. In addition, the resin composition may include a second additive for removing peroxides formed by radicals formed from the residual photoinitiator. Accordingly, the resin composition according to the embodiment may reduce yellowing of the resin layer and improve the reliability of the lighting module.

### [Description of Drawings]

FIG. 1 is a drawing showing a plan view of a lighting device according to an embodiment.
FIG. 2 is a drawing showing a partial enlarged view of FIG. 1.
FIG. 3 is a drawing showing a cross-sectional view taken along A-A of FIG. 1.
FIG. 4 is a drawing showing a partial enlarged view of FIG. 3 and explaining an optical path.
FIG. 5 is a drawing showing a detailed configuration of a reflective member of FIG. 3.
FIG. 6 is a drawing showing a removal of a reflective member of FIG. 5.
FIG. 7 is a drawing showing a mechanism for yellowing occurring in a resin layer of a lighting device according to an embodiment.
FIGS. 8 to 10 are drawings showing a relative ratio of peak areas of a photoinitiator and a peroxide decomposition agent in a resin layer measured by ³¹P-NMR.
FIG. 11 is a drawing showing another cross-sectional view of a lighting device according to an embodiment.
FIG. 12 is a drawing showing a front view of a light emitting device disposed on a substrate of a lighting device according to an embodiment.
FIG. 13 is a side view of a light emitting element of FIG. 12.
FIG. 14 is a plan view of a vehicle to which a vehicle lamp is applied.

### [Mode for Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and redisposed.

In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art. In addition, the terms used in the embodiments of the present disclosure are for describing the embodiments and are not intended to limit the present disclosure.

In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements.

Further, when expressed as "on (over)" or "under (below)", it may include not only the upper direction but also the lower direction based on one element.

A lighting device described below can be applied to various lamp devices requiring lighting, such as vehicle lamps, household lighting devices, and industrial lighting devices. For example, when the lighting devices are applied to vehicle lamps, the lighting device can be applied to head lamps, side mirror lights, side maker lights, fog lights, turn signals, tail lamps, brake lights, daytime running lights, vehicle interior lighting, door scuffs, rear combination lamps, and backup lamps. The lighting device of the present invention can be applied to indoor and outdoor advertising devices, display devices, and various types of electric vehicles. In addition, the lighting device can be applied to all lighting-related fields or advertising-related fields that are currently developed and commercialized or can be implemented in accordance with future technological developments.

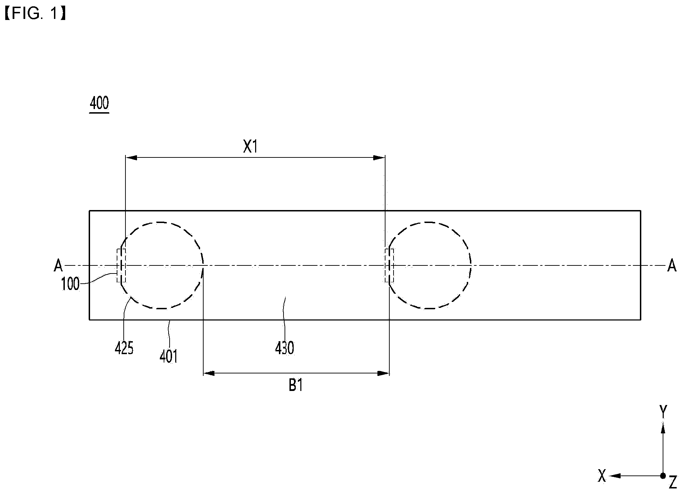

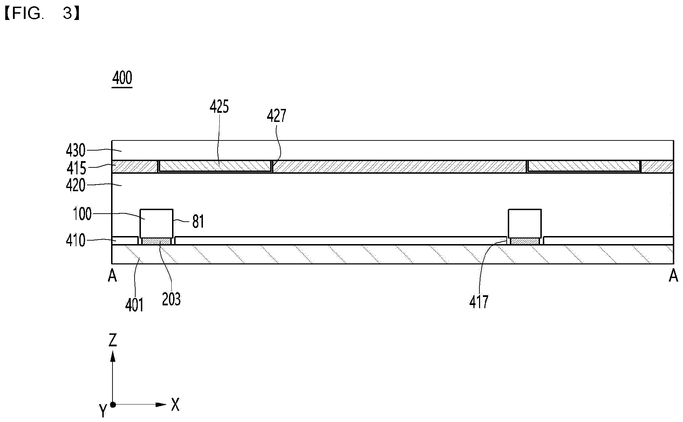

Referring to FIGS. 1 to 6, a lighting device 400 according to an embodiment may include a light emitting device 100 or a light emitting chip and a resin layer 420 covering the light emitting device 100 or a light emitting chip. The lighting device 400 may include a substrate 401 disposed under the light emitting device 100 or the light emitting chip, and the resin layer 420. The lighting device 400 may include at least one of a diffusion layer 430, a light blocking portion 425, or/and a light-transmitting layer on the resin layer 420. The lighting device 400 may include a reflective member 410 disposed between the substrate 401 and the resin layer 420.

The lighting device 400 according to an embodiment may emit the light emitted from the light emitting device 100 as a surface light source. The lighting device 400 may be defined as a light emitting cell or a light source module. The lighting device 400 may include one light emitting cell or a plurality of light emitting cells on the substrate 401.

The resin layer 420 according to the embodiment may be disposed around the light emitting device 100 or the light emitting chip. The resin layer 420 guides the light emitted from the light emitting device 100 or the light emitting chip, and may emit the guided light in a form of a surface light source through an emission surface.

The resin layer 420 may be formed by a resin composition. In detail, the resin layer 420 may be formed by a resin composition that is cured by light. More specifically, the resin layer 420 may be formed by a resin composition that is cured by ultraviolet (UV) rays.

The resin composition may include an oligomer, a monomer, a photoinitiator, and an additive. The oligomer and the monomer may be related to physical properties and/or chemical properties of the resin layer 420 formed by curing the resin composition.

In addition, the photoinitiator may serve to initiate photopolymerization of the oligomer and monomer. That is, when the ultraviolet ray is incident on the resin composition, the oligomer and the monomer may initiate a polymerization reaction by the photoinitiator.

The additive may include an antioxidant. Specifically, the additive may prevent denaturation of the resin layer 420 formed by curing the resin composition. For example, the additive may serve to prevent an intermolecular bond of the resin layer 420 from being broken or an occurrence of yellowing of the resin layer 420 due to an intermediate product.

The resin layer 420 formed by curing the resin composition may include a photoinitiator remaining after curing. The photoinitiator may generate radicals by heat, and these radicals may break the intermolecular bond of the resin layer or form an intermediate product that reacts with the radicals to bind. Accordingly, a yellowing phenomenon may occur in the resin layer 420, which may reduce the reliability of the resin layer.

Therefore, hereinafter, a resin composition capable of reducing the yellowing phenomenon of the resin layer 420 will be described in detail.

The resin composition may include an oligomer, a monomer, a photoinitiator, and an additive.

The oligomer may be related to properties of ductility, smoothness, tensile strength, and adhesive strength of the resin layer 420.

The oligomer may include an urethane acrylate. In detail, the oligomer may include at least one oligomer among a first oligomer and a second oligomer. For example, the oligomer may include a first oligomer including a urethane acrylate of a tetramethylene glycol series. In addition, the oligomer may include a second oligomer including a urethane acrylate of an ethylene glycol series.

The oligomer may be contained in a set weight % range relative to a total weight of the resin composition. Specifically, the oligomer may be contained in an amount of 8 wt% or more relative to the total weight of the resin composition. More specifically, the oligomer may be contained in an amount of 10 wt% to 25 wt% relative to the total weight of the resin composition.

If the oligomer is contained in an amount of less than 10 wt% relative to the total weight of the resin composition, at least one of the properties of the resin layer implemented by the oligomer, such as ductility, smoothness, tensile strength, and adhesive strength, may be reduced. In addition, if the oligomer is contained in an amount of more than 25 wt% relative to the total weight of the resin composition, the properties of the resin layer implemented by the oligomer may be maintained. However, this may affect a composition ratio of other compositions, and overall, the properties of the resin layer for the optical application may be reduced.

The first oligomer and the second oligomer may be contained in different weight %s. For example, the second oligomer may be contained in a weight % smaller than the second oligomer. In detail, the weight % of the second oligomer may be 10% or more of the weight % of the first oligomer. More specifically, the weight % of the second oligomer may be 10% to 70% of the weight % of the first oligomer.

For example, the first oligomer may be contained in an amount of 8% or more of the total weight of the resin composition. In detail, the first oligomer may be contained in an amount of 8% to 20% of the total weight of the resin composition.

In addition, the second oligomer may be contained in an amount of 1% or more of the total weight of the resin composition. In detail, the second oligomer may be contained in an amount of 1% to 5% of the total weight of the resin composition.

By setting the weight % of the first oligomer and the second oligomer as described above, the properties of ductility, smoothness, tensile strength, and adhesive strength of the resin composition can be stably formed.

The monomer may be related to the properties of hardness, transparency, adhesion, and heat resistance of the resin layer 420.

The monomer may include an acrylate monomer. Specifically, the monomer may include a first monomer, a second monomer, a third monomer, and a fourth monomer. For example, the above monomer may include a first monomer including IBOA (Isobonyl acrylate). In addition, the monomer may include a second monomer including at least one of EHA (2-Ethylhexyl acrylate) and LA (Lauryl Acrylate). In addition, the monomer may include a third monomer including at least one of CA (Caprolactone acrylate) and 2-(2-Ethoxyethoxy)ethyl acrylate. In addition, the monomer may include a fourth monomer including at least one of Glycidyl methacrylate (GMA) and 3,4-epoxycyclohexylmethyl methacrylate.

The monomer may be contained in a set weight % range relative to the total weight of the resin composition. In detail, the monomer may be contained in an amount of 60 wt% or more relative to the total weight of the resin composition. More specifically, the monomer may be contained in an amount of 60 wt% to 70 wt% relative to the total weight of the resin composition.

If the monomer is contained in an amount of less than 60 wt% relative to the total weight of the resin composition, at least one of the hardness, transparency, adhesion, and heat resistance, which are properties of the resin layer implemented by the monomer, may be reduced. In addition, if the monomer is contained in an amount of more than 70 wt% relative to the total weight of the resin composition, the properties of the resin layer implemented by the monomer may be maintained. However, this may affect the composition ratio of other compositions, and the properties of the resin layer for optical application as a whole may decrease.

The first monomer, the second monomer, the third monomer, and the fourth monomer may be contained in different weight %. For example, the first monomer may be contained in a greater weight % than the second monomer, the third monomer, and the fourth monomer. In addition, the third monomer may be contained in a greater weight % than the second monomer and the fourth monomer.

For example, the first monomer may be contained in an amount of 40 wt% or more based on the total weight of the resin composition. Specifically, the first monomer may be contained in an amount of 40 wt% to 50 wt% based on the total weight of the resin composition.

In addition, the second monomer may be contained in an amount of 3 wt% or more based on the total weight of the resin composition. Specifically, the second monomer may be contained in an amount of 3 wt% to 18 wt% based on the total weight of the resin composition.

In addition, the third monomer may be contained in an amount of 15 wt% or more based on the total weight of the resin composition. Specifically, the third monomer may be contained in an amount of 15 wt% to 30 wt% based on the total weight of the resin composition.

In addition, the fourth monomer may be contained in an amount of 7 wt% or more based on the total weight of the resin composition. Specifically, the fourth monomer may be contained in an amount of 7 wt% to 14 wt% based on the total weight of the resin composition.

By setting the weight % of the first monomer, the second monomer, the third monomer, and the fourth monomer as described above, the hardness, transparency, adhesion, and heat resistance properties of the resin composition can be stably formed.

Meanwhile, the monomer may further include a polymerization inhibitor. The polymerization inhibitor may serve to prevent the resin composition from being polymerized again after the resin layer is formed by curing the resin composition.

The photoinitiator serves to initiate polymerization of the oligomer and the monomer.

The photoinitiator may have a decomposition temperature (TD) of a set size. In detail, the decomposition temperature of the photoinitiator may be 150°C or higher. In more detail, the decomposition temperature of the photoinitiator may be 170°C or higher. In more detail, the decomposition temperature of the photoinitiator may be 150°C to 250°C.

If the decomposition temperature of the photoinitiator is less than 150°C, yellowing may occur in the resin layer due to the photoinitiator. That is, since the photoinitiator has low thermal stability, the photoinitiator can easily generate radicals by heat generated during operation of the lighting device including the resin layer. Accordingly, yellowing occurring in the resin layer may increase due to radicals generated from the photoinitiator.

The photoinitiator may include a long-wavelength photoinitiator. That is, the photoinitiator may have a large peak in a wavelength range of an ultraviolet region. In detail, the photoinitiator may absorb light in a wavelength band of a set range. In detail, the photoinitiator may absorb light in a wavelength band of 250 nm or more. More specifically, the photoinitiator may absorb light in a wavelength band of 250 nm to 400 nm.

If the photoinitiator absorbs light in a wavelength band of less than 250 nm, the photoinitiator may become a short-wavelength photoinitiator, and thereby the overall absorption wavelength band of the photoinitiator may be widened to an infrared region. Accordingly, since the photoinitiator can absorb light of the lighting device, and thus can absorb light emitted from the light emitting device of the lighting device, a brightness of the lighting device can be reduced.

In addition, if the photoinitiator absorbs light in a wavelength band exceeding 400 nm, the photoinitiator absorbs light in an infrared region, and thus the brightness of the lighting device can be reduced.

The photoinitiator may include phosphorus (P). The photoinitiator may include a phosphorus-based photoinitiator. In detail, the photoinitiator may include a photoinitiator represented by a following structural formula 1. That is, the photoinitiator may include Diphenyl(2,4,6-trimethylbenzoyl)phosphine oxide.

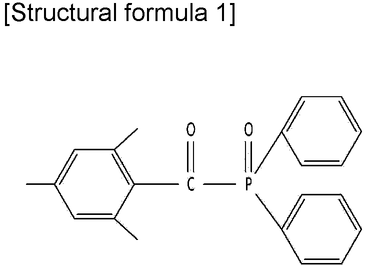

The photoinitiator may be contained in a set weight % range relative to the total weight of the resin composition. Specifically, the photoinitiator may be contained in an amount of 0.5 wt% or more relative to the total weight of the resin composition. More specifically, the photoinitiator may be contained in an amount of 0.5 wt% to 1.2 wt% relative to the total weight of the resin composition.

If the photoinitiator is contained in an amount of less than 0.5 wt% relative to the total weight of the resin composition, the polymerization reaction of the monomer and the oligomer may be reduced by the photoinitiator, so that the resin composition may not be partially cured. In addition, if the photoinitiator is contained in an amount of more than 1.2 wt% relative to the total weight of the resin composition, the photoinitiator remaining after the resin composition is cured may increase. Accordingly, yellowing formed in the resin layer due to the remaining photoinitiator may increase.

The additive may include an antioxidant. The additive may include a first additive and a second additive.

The first additive may include a radical removing agent. In detail, the first additive can remove radicals generated from the photoinitiator or polymerization inhibitor. For example, the first additive can form alcohol by combining with radicals generated from the photoinitiator or polymerization inhibitor.

The first additive can include an additive represented by at least one of following structural formulas 2, 3, and 4.

For example, the first additive can be Bis (1, 2, 2, 6, 6-pentamethyl-4-piperidyl) sebacate of the following structural formula 2.

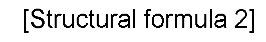

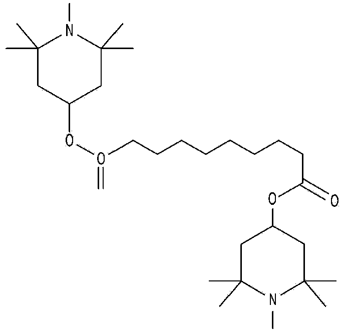

Alternatively, the first additive may be Bis (2,2,6,6-tetramethyl-4-piperidyl)sebacate of the following structural formula 3.

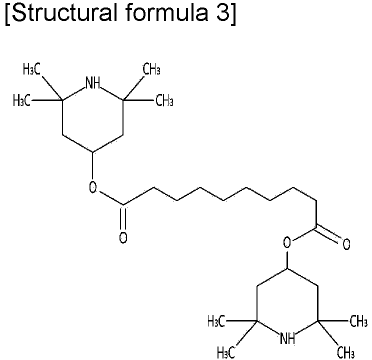

Alternatively, the first additive may be Bis (1-octyloxy-2, 2, 6, 6-tetramethyl-4-piperidyl) sebacate of the following structural formula 4.

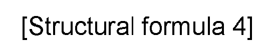

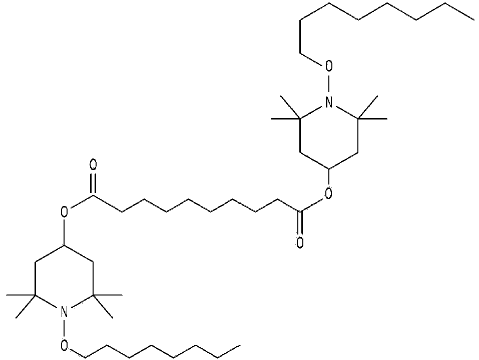

The first additive may be contained in a weight % of a set range. Specifically, the first additive may be contained in an amount of 0.3 wt% or more based on the total weight of the resin composition. The first additive may be contained in an amount of 0.3 wt% to 0.9 wt% based on the total weight of the resin composition.

If the first additive is contained in an amount of less than 0.3 wt% based on the total weight of the resin composition, a radical removal effect by the first additive is reduced. Accordingly, yellowing may occur in the resin layer, thereby reducing a light transmittance of the resin layer. In addition, if the first additive is contained in an amount of more than 0.9 wt% based on the total weight of the resin composition, the light transmittance of the resin layer may be reduced by a color of the first additive. That is, the color of the radical removing agent (for example, a yellow color) may affect a color of the resin layer. Therefore, the transparency of the resin layer may be reduced, thereby reducing the light transmittance of the resin layer.

The second additive may include a peroxide decomposition agent. Specifically, the second additive may remove peroxide, which is an intermediate product formed by radicals generated from the photoinitiator or polymerization inhibitor. For example, the second additive may react with peroxide, which is an intermediate product formed by combining with radicals generated from the photoinitiator or polymerization inhibitor, to remove the peroxide.

The second additive may include phosphorus (P). The second additive may include a phosphorus-based additive. The second additive may include an additive represented by at least one of following structural formulas 5, 6, 7, 8, and 9.

That is, the second additive may be Bis-(2,4-di-tert.-butylphenol)pentaerythritol diphosphite of the following structural formula 5.

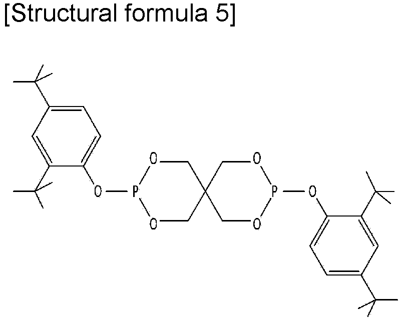

Alternatively, the second additive may be Bis(2,6-di-tert-butyl-4-methylphenyl)-pentaerythritol diphosphite of the following structural formula 6.

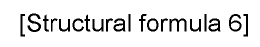

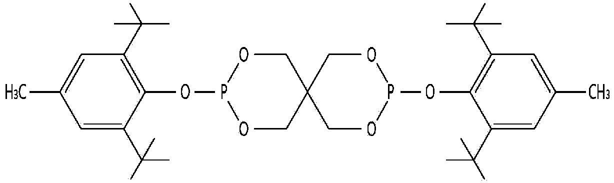

Alternatively, the second additive may be 3,9-Bis(octadecyloxy)-2,4,8,10-tetraoxa-3,9-diphosphaspiro[5.5]undecane of the following structural formula 7.

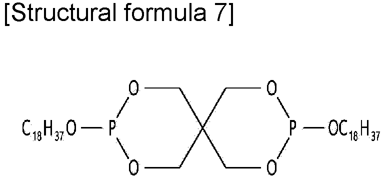

Alternatively, the second additive may be 2, 2'-Methylene bis(4, 6-di-tert-butylphenyl) iso-octanol phosphate of the following structural formula 8.

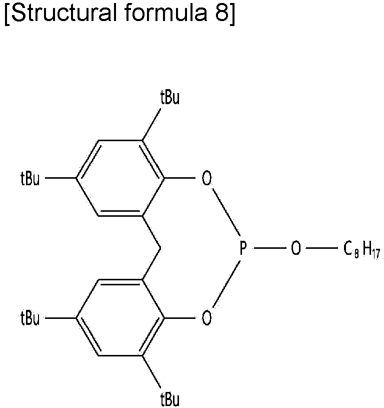

Alternatively, the second additive may be Tris(2,4-ditert-butylphenyl) phosphite of the following structural formula 9.

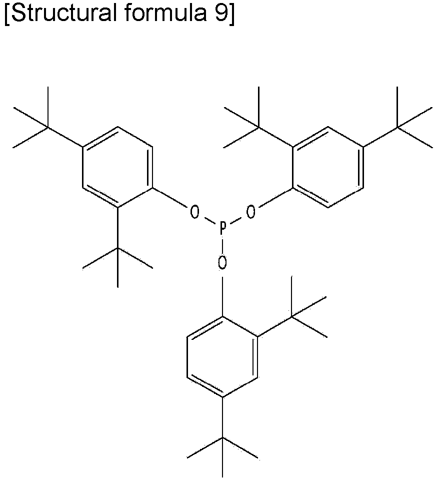

The second additive may be contained in a set weight % range relative to the total weight of the resin composition. Specifically, the second additive may be contained in an amount of 0.2 wt% or more relative to the total weight of the resin composition. More specifically, the second additive may be contained in an amount of 0.2 wt% to 0.7 wt% relative to the total weight of the resin composition.

If the second additive is contained in an amount of less than 0.2 wt% relative to the total weight of the resin composition, the peroxide cannot be effectively removed by the second additive. In addition, if the second additive is contained in an amount of more than 0.7 wt% relative to the total weight of the resin composition, the additive remaining after the resin composition is cured may form phosphoric acid, thereby forming yellowing in the resin layer.

Therefore, the total weight of the additive including the first additive and the second additive may be 0.5 wt% to 1.6 wt% relative to the total weight of the resin composition. In addition, the weight % of the additive and the weight % of the photoinitiator may be different. Specifically, the weight % of the photoinitiator may be greater than the weight % of each of the first additive and the second additive.

As the weight % of the photoinitiator is contained in a larger amount than the weight % of the additive, the reliability of the resin layer may be improved. Specifically, as the weight % of the photoinitiator is contained in a larger amount than the weight % of the additive, the heat resistance and moisture resistance of the resin layer may be increased.

In addition, the weight % of the first additive and the weight % of the second additive may be different. Specifically, the weight % of the first additive may be greater than the weight % of the second additive. For example, in the weight % range of the first additive and the second additive, the weight % of the first additive may be greater than the weight % of the second additive.

As the weight % of the first additive is contained in a larger amount than the weight % of the second additive, the reliability of the resin layer may be improved. In detail, as the weight % of the first additive is contained larger than the weight % of the second additive, the heat resistance and moisture resistance of the resin layer can be increased.

The resin composition can improve the reliability of the resin layer formed by curing the resin composition.

In detail, the photoinitiator of the resin composition can have a decomposition temperature of a set size range. Accordingly, the photoinitiator can have improved heat resistance. Accordingly, when the lighting device including the resin layer is applied to a vehicle or the like and operates, the decomposition of the photoinitiator due to the heat generated can be reduced. That is, the photoinitiator can be prevented from being decomposed to form radicals. Accordingly, the occurrence of yellowing of the resin layer can be reduced.

In addition, the photoinitiator of the resin composition can absorb a wavelength of a set size range. Accordingly, the photoinitiator can minimize absorption of light in the infrared wavelength band. Accordingly, the photoinitiator can be prevented from absorbing blue light emitted from the light emitting device, so that the decrease in brightness of the lighting device can be prevented.

In addition, the resin composition may include an additive. Accordingly, yellowing in the resin layer may be reduced.

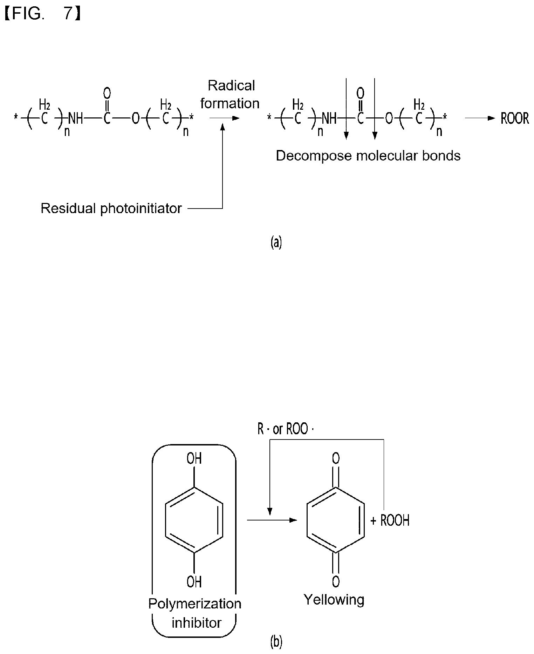

FIG. 7 is a drawing showing a mechanism for yellowing occurring in a resin layer of a lighting device according to an embodiment.

FIG. 7 (a) is a drawing for explaining yellowing that occurs due to breaking of intermolecular bonds in the resin layer after the resin composition is cured, and FIG. 7 (b) is a drawing for explaining yellowing that is formed by a polymerization inhibitor included in the monomer.

Referring to FIG. 7 (a), a residual photoinitiator may be decomposed when heat is applied at a temperature above a set range. The residual photoinitiator may form radicals while being decomposed. The bonds of the polymerized resin composition may be decomposed by these radicals, and yellowing may occur in the resin layer as a result.

In addition, an intermediate product may be generated due to the reaction of the radical, and yellowing may occur in the resin layer due to this intermediate product.

In addition, referring to (b) of FIG. 7, when the radical generated from the residual photoinitiator reacts with the polymerization inhibitor, the polymerization inhibitor is decomposed, and thus yellowing may occur in the resin layer.

The resin composition according to the embodiment may include a first additive that removes the radical formed from the residual photoinitiator. In addition, the resin composition may include a second additive that removes the peroxide formed by the radical formed from the residual photoinitiator. Accordingly, the resin composition according to the embodiment may reduce yellowing of the resin layer and improve the reliability of the lighting module.

Hereinafter, the present invention will be described in more detail through resin compositions according to the embodiments and comparative examples. These embodiments are merely presented as examples in order to describe the present invention in more detail. Therefore, the present invention is not limited to these embodiments.

Resin compositions of the embodiments and comparative examples 1 to 4 having compositions shown in Table 1 below are prepared.

Next, the resin composition is cured to form a resin layer, and then the reliability in high-temperature operation, thermal shock, and high-temperature/high-humidity operation are measured.

In addition, after only changing the weight % of the photoinitiator and additive in the resin composition according to the embodiment of Table 1, the reliability in high-temperature operation, thermal shock, and high-temperature/high-humidity operation are measured.

The reliability in high-temperature operation is evaluated after 1000 hours at a temperature of 105°C, the reliability in thermal shock is evaluated after 1000 times at temperatures of -40°C and 105°C, and the reliability in high-temperature/high-humidity operation is evaluated after 1000 hours at a temperature of 85°C and a humidity of 85%.

**[Table 1]**

| | | embodime nt (wt%) | comparati ve example 1 (wt%) | comparati ve example 2 (wt%) | comparativ e example 3 (wt%) | comparative example 4 (wt%) |
|---|---|---|---|---|---|---|
| Oligo mer | Urethane acrylate (tetramethylene glycol series) | 16.9 | 17.3 | 16.7 | 16.7 | 17.2 |
| | Urethane acrylate (ethylene glycol series) | 3.0 | 3.0 | 3.0 | 2.8 | 3.4 |
| Mono mer | Isobonyl | 44.6 | 44.8 | 44.5 | 44.8 | 44.6 |
| | acrylate (IBOA) | | | | | |
| | 2-Ethylhexyl acrylate (EHA) | 4.0 | 4.1 | 3.8 | 3.5 | 3.8 |
| | Caprolactone acrylate (CA) | 16.9 | 17.0 | 16.9 | 17.2 | 17.1 |
| | Glycidyl methacrylate (GMA) | 12.9 | 13.0 | 12.9 | 13.1 | 13.4 |
| Photo initiat or | Irgacure TPO | 1.0 | 0.1 | 1.5 | 1.0 | 1.0 |
| Additi ves | Additive1 | 0.5 | 0.5 | 0.5 | 0.5 | 0.5 |
| | Additive2 | 0.3 | 0.3 | 0.3 | 0.1 | 1.5 |

| | | | | | | |
|---|---|---|---|---|---|---|
| (Irgacure TPO: Diphenyl(2,4,6-trimethylbenzoyl)phosphine oxide, first additive: Bis (1, 2, 2, 6, 6-pentamethyl-4-piperidyl) sebacate Second additive: Bis-(2,4-di-tert.-butylphenol)pentaerythritol diphosphite)) | | | | | | |

**[Table 2]**

| | high-temperature operation | thermal shock | high-temperature/high-humidity operation |
|---|---|---|---|
| embodiment 1 | Pass | Pass | Pass |
| comparative example 1, 2 | Pass | Pass | 750 hours |
| comparative example 3, 4 | Pass | Pass | 900 hours |

Referring to Table 2, it can be seen that the resin layer cured by the resin composition according to the embodiment 1 has improved reliability compared to the resin layer cured by the resin composition according to the comparative examples 1 to 4.

That is, the resin layer cured by the resin composition according to the embodiment can have stable reliability in high-temperature operation, thermal shock, and high-temperature/high-humidity operation because the weight % of the photoinitiator and additive of the resin composition satisfies the set range.

On the other hand, the resin layer cured by the resin composition according to the comparative examples 1 to 4 cannot have stable reliability in high-temperature/high-humidity operation because the weight % of the photoinitiator and additive of the resin composition satisfies the set range.

**[Table 3]**

| Photoinitiato r | Additive 1 | Additive 2 | high-temperature operation | thermal shock | high-temperature/high-humidity operation |
|---|---|---|---|---|---|
| 1% | 0.5% | 0% | Pass | Pass | 700 hours |
| 1% | 0.5% | 0.1% | Pass | Pass | 950 hours |
| 1% | 0.5% | 0.2% | Pass | Pass | 1100 hours |
| 1% | 0.5% | 0.3% | Pass | Pass | 1200 hours |
| 1% | 0.5% | 0.5% | Pass | Pass | 1090 hours |
| 1% | 0.5% | 0.7% | Pass | Pass | 1030 hours |
| 1% | 0.5% | 1% | Pass | Pass | 990 hours |

| | | | | | |
|---|---|---|---|---|---|
| (Photoinitiator: Diphenyl(2,4,6-trimethylbenzoyl)phosphine oxide, Additive 1: Bis(1, 2, 2, 6, 6-pentamethyl-4-piperidyl) sebacate Additive 2: Bis-(2,4-di-tert.-butylphenol)pentaerythritol diphosphite)) | | | | | |

Referring to Table 3, it can be seen that the resin layer cured by the resin composition according to the embodiment has improved reliability within the weight % range of the photoinitiator and additive set.

That is, referring to Table 3, it can be seen that the resin layer cured by the resin composition according to the embodiment has improved reliability when the weight % of the photoinitiator of the resin composition is contained at least the total weight % of the additive.

In addition, it can be seen that the resin layer cured by the resin composition according to the embodiment has improved reliability when the weight % of the additive 1 of the resin composition is contained at least the weight % of the additive 2. That is, it can be seen that the resin layer cured by the resin composition according to the embodiment has improved reliability when the weight % of the radical removing agent of the resin composition is contained more than the weight % of the peroxide decomposition agent.

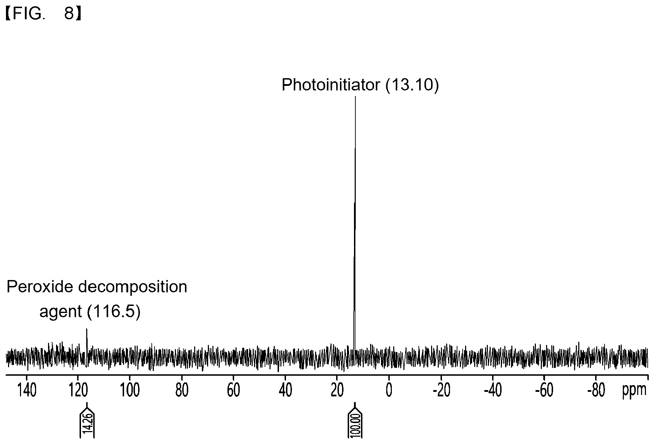

FIGS. 8 to 10 are drawings showing a relative ratio of peak areas of a photoinitiator and a peroxide decomposition agent in a resin layer measured by ³¹P-NMR.

FIGS. 8 to 10 are peak data of ³¹P-NMR measured while the weight % of the photoinitiator of the resin layer is fixed and the weight % of the second additive is varied.

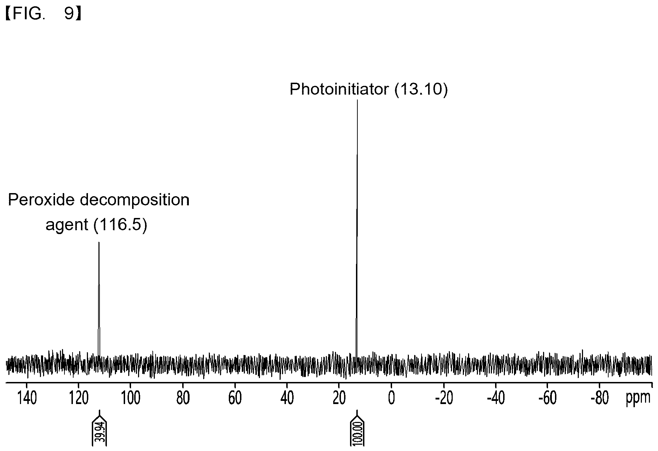

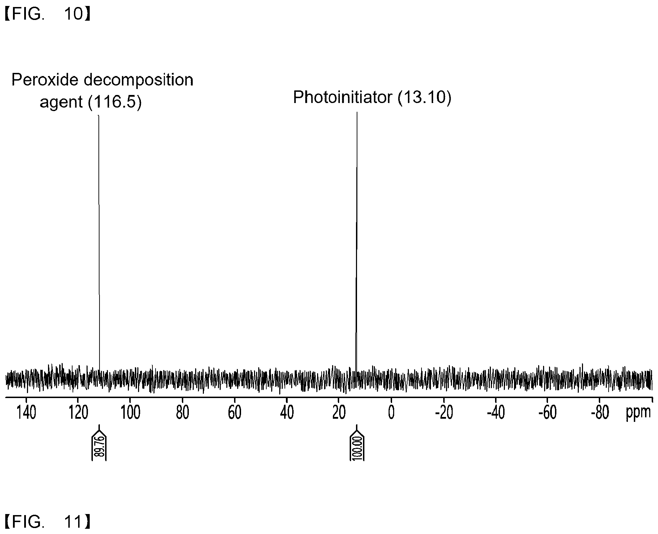

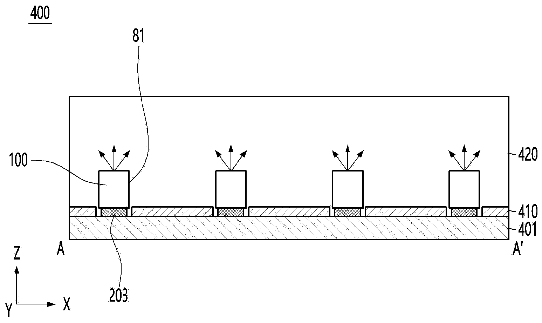

In detail, FIG. 8 is relative peak data when the photoinitiator of the resin layer is contained in an amount of 1 wt% and the second additive contained in an amount of 0.1 wt%. FIG. 9 is relative peak data when the photoinitiator of the resin layer is contained in an amount of 1 wt% and the second additive is contained in an amount of 0.3 wt%. FIG. 10 is relative peak data when the photoinitiator of the resin layer is contained in an amount of 1 wt% and the second additive is contained in an amount of 0.7 wt%. Here, the relative peak data means a relative position of the second additive detected by chemical shift based on a photoinitiator peak position and the relative data of an area of the second additive detected based on an area of the photoinitiator peak as 100. Specifically, referring to FIG. 8, a photoinitiator peak position is 13.10, and a position of the second additive detected by chemical shift from this is 116.5, and an area of the second additive is 14.26% of an area of the photoinitiator.

The ³¹P-NMR of the resin layer was measured using a same amount of sample after dissolving the resin layer in a CDCl3 solvent or a Trifluoroacetic acid solvent to form a sample. Then, the peak and peak area of the photoinitiator and the second additive were measured.

Referring to FIGS. 8 to 10, the photoinitiator and the second additive of the resin composition according to the embodiment may have different peak areas. Specifically, the resin composition may have a peak area of a photoinitiator having a large peak height greater than a peak area of a second additive having a small peak height.

The peak area of the photoinitiator and the peak area of the second additive may have a ratio within a set range. Specifically, the peak area of the second additive may be 10% or more of the peak area of the photoinitiator. More specifically, the peak area of the second additive may be 40% or more of the peak area of the photoinitiator. More specifically, the peak area of the second additive may be 90% or less of the peak area of the photoinitiator.

For example, the peak area of the second additive may be 10% or more to 90% of the peak area of the photoinitiator.

If the peak area of the second additive is less than 10% of the peak area of the photoinitiator, yellowing of the resin layer may increase. As a result, the reliability of the lighting device to which the resin layer is applied may decrease. In addition, if the peak area of the second additive is more than 90% of the peak area of the photoinitiator, the second additive may form phosphoric acid, and yellowing of the resin layer may increase. As a result, the reliability of the lighting device to which the resin layer is applied may decrease.

Hereinafter, other configurations of the lighting device will be described in detail with reference to FIGS. 1 to 6.

### Substrate 401

Referring to FIGS. 1 to 4, the substrate 401 may include a printed circuit board (PCB). The substrate 410 may include, for example, at least one of a resin-based printed circuit board (PCB), a PCB having a metal core, a flexible PCB, a ceramic PCB, or an FR-4 substrate. When the substrate 401 is disposed as a metal core PCB having a metal layer disposed on the bottom, the heat dissipation efficiency of the light emitting device 100 may be improved.

The substrate 401 may be electrically connected to the light emitting device 100. The substrate 401 includes a wiring layer (not shown) thereon, and the wiring layer may be electrically connected to the light emitting device 100. When a plurality of the light emitting devices 100 are arranged on the substrate 401, the plurality of light emitting devices 100 may be connected in series, parallel, or series-parallel by the wiring layer. The substrate 401 may function as a base member or a support member disposed under the light emitting device 100 and the resin layer 420.

The upper surface of the substrate 401 may have an X-Y plane. The upper surface of the substrate 401 may be flat or have a curved surface. The thickness of the substrate 401 may be a vertical direction or a height in the Z direction. Here, in the X-Y plane, the X direction may be a first direction, and the Y direction may be a second direction. The Z direction may be a direction orthogonal to the first and second directions. A length of the substrate 401 in the first direction may be greater than a width in the second direction. The length of the substrate 401 in the first direction may be two times or more, for example, four times or more than the width Y1 in the second direction. The plurality of light emitting devices 100 may be arranged on the substrate 401 at a predetermined interval in the first direction. The substrate 401 may be provided in a straight or curved bar shape in a lengthwise direction. The substrate 401 may include a light-transmitting material through which light is transmitted through the upper and lower surfaces. The light-transmitting material may include at least one of polyethylene terephthalate (PET), polystyrene (PS), and polyimide (PI).

The substrate 401 may include, for example, a reflective member 410. The reflective member 410 may be an insulating layer for protecting a circuit pattern having a pad disposed on the substrate 401 or a layer of a reflective material.

### Light emitting device 100

Referring to FIGS. 1 to 4, the light emitting device 100 is disposed on the substrate 401 and emits light in a first direction. The light emitting device 100 emits light having the highest intensity in the first direction. The light emitting device 100 may have an emission surface 81 from which light is emitted, and the emission surface 81 is disposed, for example, in a third direction or a vertical direction with respect to a horizontal upper surface of the substrate 401. The emission surface 81 may be a vertical plane, or may include a concave surface or a convex surface. As shown in FIGS. 7 and 8, the light emitting device 100 may be disposed on, for example, the substrate 401 and electrically connected to the pads 403 and 405 of the substrate 401 by conductive bonding members 203 and 205. The conductive bonding members 203 and 205 may be made of a solder material or a metal material.

As another example, the light emitting devices 100 may be arranged on the substrate 401 in at least one row in the second direction, or may be arranged in two or more rows, and the light emitting devices 100 in one or more rows or more may be disposed in the first direction of the substrate 401 or may be disposed in different directions. The light emitting device 100 may be arranged in an M×N matrix, and the M and N may be integers of 2 or more.

As another example, the light emitting device 100 may be disposed as a first light emitting device from one end of the substrate 401 and a second light emitting device in an emission direction of the first light emitting device. The first light emitting device and the second light emitting device emit light in the direction of the other end or the first direction of the substrate 401. That is, the first light emitting device irradiates light in the direction of the second light emitting device, and the second light emitting device irradiates light in the direction opposite to the other end of the substrate 401 or the direction on which the first light emitting device is disposed.

The light emitting device 100 may include a device having a light emitting chip 71 in a body or a package in which the light emitting chip 71 is packaged. The light emitting chip 71 may be molded by the molding member 80. The emission surface 81 may be a surface of the molding member 80. The molding member 80 may be made of a transparent resin material such as silicone or epoxy. The light emitting chip 71 may emit at least one of blue, red, green, ultraviolet (UV) and infrared light, and the light emitting device 100 may emit at least one of white, blue, red, green, and infrared light. The light emitting device 100 may be of a side view type in which a bottom portion is electrically connected to the substrate 401, but is not limited thereto. As another example, the light emitting device 100 may be an LED chip or a top-view package.

The emission surface 81 of the light emitting device 100 may be disposed on at least one side of the light emitting device 100 rather than the upper surface. The emission surface 81 may be a side adjacent to the substrate 401 among the side surfaces of the light emitting device 100 or a side perpendicular to the upper surface of the substrate 401. The emission surface 81 is disposed on a side surface between the bottom surface and the upper surface of the light emitting device 100, and emits light of the highest intensity in the first direction. The emission surface 81 of the light emitting device 100 may be a surface adjacent to the reflective member 410 or a surface perpendicular to the upper surface of the substrate 401 or the upper surface of the reflective member 410.

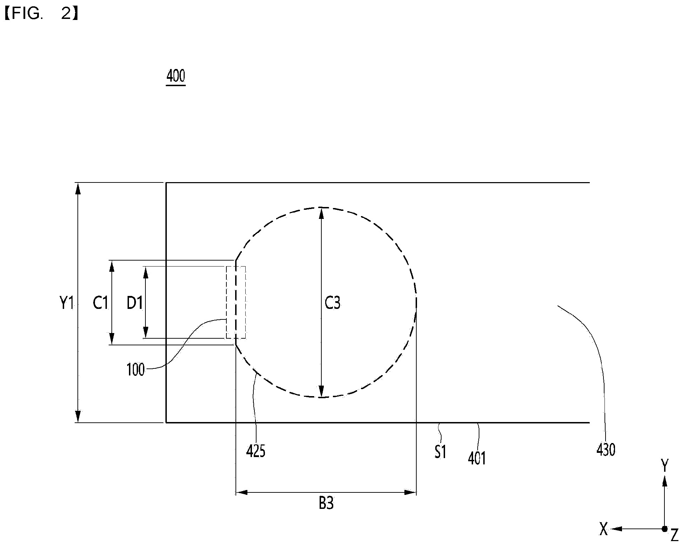

Some light emitted through the emission surface 81 of the light emitting device 100 travels in a direction parallel to the top surface of the substrate 401, is reflected by the reflective member 410, or may proceed in the direction of the upper surface of the resin layer 420. The thickness of the light emitting device 100 may be, for example, 3 mm or less, for example, in the range of 0.8 mm to 2 mm. A length (D1 of FIG. 2) in the second direction of the light emitting device 100 may be 1.5 times or more of a thickness of the light emitting device 100. In the light emitting device 100, the distribution of the light emitted in the X direction may have a wider light directivity angle in the ±Y direction than the light directivity angle in the ±Z direction. The light directivity angle of the light emitting device 100 in the second direction may be 110 degrees or more, for example, 120 degrees to 160 degrees or 140 degrees or more. The light directivity angle of the light emitting device 100 in the third direction may be 110 degrees or more, for example, in a range of 120 degrees to 140 degrees.

### Reflective member 410

Referring to FIGS. 1 to 4, the reflective member 410 may be a layer separately disposed on the substrate 401 or a layer protecting the upper portion of the substrate 401. The reflective member 410 may be disposed between, for example, the substrate 401 and the resin layer 420. The reflective member 410 may be provided in the form of a film having a metal material or a non-metal material. The reflective member 410 may be adhered to the upper surface of the substrate 401. The reflective member 410 may have an area smaller than an area of a upper surface of the substrate 401. The reflective member 410 may be spaced apart from the edge of the substrate 401, and a resin layer 420 may be attached to the substrate 401 in the spaced apart region. In this case, it is possible to prevent the edge portion of the reflective member 410 from peeling off.

The reflective member 410 may include an opening 417 in which a lower portion of the light emitting device 100 is disposed. In the opening 417 of the reflective member 410, the upper surface of the substrate 401 may be exposed and a portion to which the lower portion of the light emitting device 100 is bonded may be disposed. The size of the opening 417 may be the same as or larger than the size of the light emitting device 100, but is not limited thereto. The reflective member 410 may contact the upper surface of the substrate 401 or may be adhered between the resin layer 420 and the substrate 401, but is not limited thereto. Here, the reflective member 410 may be removed when a highly reflective material is coated on the upper surface of the substrate 401.

The reflective member 410 may be formed to have a thickness smaller than that of the light emitting device 100. The thickness of the reflective member 410 may include a range of 0.2 mm ± 0.02 mm. A lower portion of the light emitting device 100 may penetrate through the opening 417 of the reflective member 410 and an upper portion of the light emitting device 100 may protrude. The emission surface 81 of the light emitting device 100 may be provided in a direction perpendicular to the upper surface of the reflective member 410.

The reflective member 410 may include a metallic material or a non-metallic material. The metallic material may include a metal such as aluminum, silver, or gold. The non-metallic material may include a plastic material or a resin material. The plastic material may be any one selected from the group consisting of polyethylene, polypropylene, polystyrene, polyvinyl chloride, polybiphenyl chloride, polyethylene terephthalate, polyvinyl alcohol, polycarbonate, polybutylene terephthalate, polyethylene naphthalate, polyamide, polyacetal, polyphenylene, polyamideimide, polyetherimide, polyetheretherketone, polyimide, polytetrafluoroethylene, liquid crystal polymer, fluororesin, copolymers thereof, and mixtures thereof. As the resin material, a reflective material, for example, a metal oxide such as TiO2, Al2O3, or SiO2 may be added in silicon or epoxy. The reflective member 410 may be implemented as a single layer or a multilayer, and light reflection efficiency may be improved by such a layer structure. The reflective member 410 according to an embodiment of the invention reflects incident light, thereby increasing the amount of light so that the light is emitted with a uniform distribution.

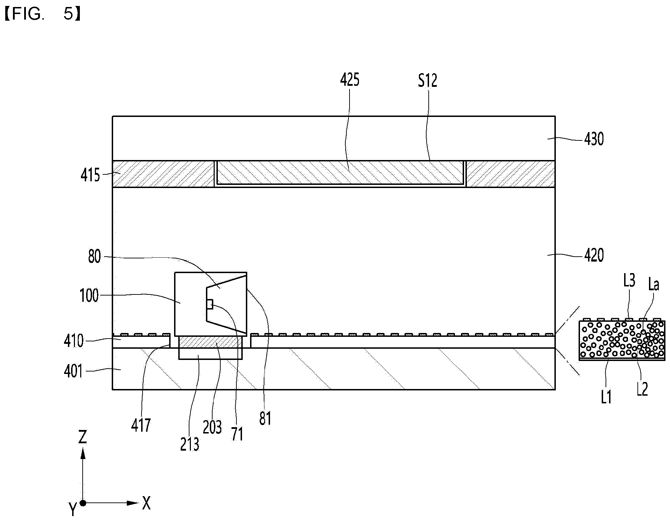

Referring to FIG. 5, the reflective member 410 may include an adhesive layer L1, a reflective layer L2, and a dot layer L3. The adhesive layer L1 may attach the reflective member 410 to the upper surface of the substrate 401. The adhesive layer L1 is a transparent material, and may be an adhesive such as UV adhesive, silicone, or epoxy.

The reflective layer L2 may include a plurality of reflective agents La in a resin material. The reflective agents La may be a bubble such as air or a medium having the same refractive index as air. A resin material of the reflective layer L2 may be a material such as silicone or epoxy, and the reflective agents La may be formed by injecting air bubbles into the resin material. The reflective layer L2 may reflect the light incident by the plurality of reflective agents La or refract it in a different direction. The thickness of the reflective layer L2 may be 80% or more of the thickness of the reflective member 410. The dot layer L3 in which a plurality of dots is arranged may be included on the reflective layer L2. The dot layer L3 may be formed on the reflective layer L2 by printing. The dot layer L3 may include a reflective ink. The dot layer L3 may be printed with a material including any one of TiO2, CaCO3, BaSO4, Al2O3, Silicon, or PS. Each dot of the dot layer L3 may have a hemispherical or a polygonal shape in a side cross-section. The density of the dot pattern of the dot layer L3 may be increased as the distance from the emission surface 81 of the light emitting device 100 increases. The material of the dot layer L3 may be white.

Since the dot layer L3 is disposed on the upper surface of the reflective layer L2 in the emission direction of the light emitting device 100, it is possible to improve light reflectance, reduce light loss, and improve the luminance of the surface light source.

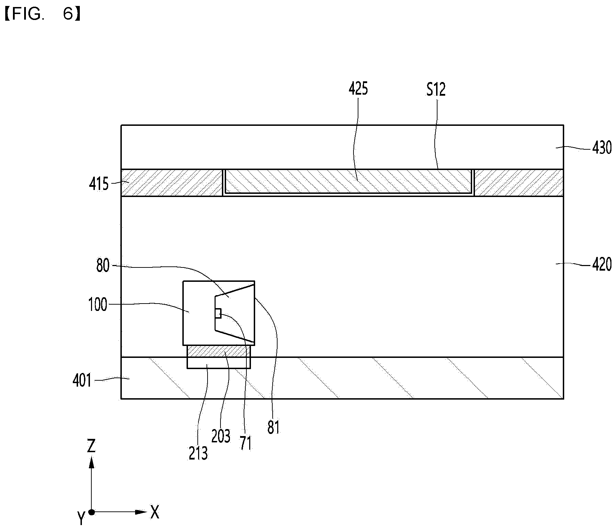

As another example of the lighting device, the reflective member 410 may be removed from the substrate 401. For example, as shown in FIG. 6, the resin layer 420 may be disposed on the substrate 401 without a reflective member, and the resin layer 420 may be in contact with the upper surface of the substrate 401. In the absence of a reflective member, a metal oxidation problem may occur when the pads 403 and 405 are exposed on the substrate 401, and the resin layer 420 may suppresses metal oxidation in which the metal material is combined with oxygen. That is, the resin layer 420 may suppress metal oxidation caused by moisture by removing the acrylate having a hydroxyl group.

### Resin layer 420

The resin layer 420 may be formed by curing the resin composition described above. The resin layer 420 may be disposed on the substrate 401. The resin layer 420 may face or adhere to the substrate 401. The resin layer 420 may be disposed on all or a portion of the upper surface of the substrate 401. The area of the lower surface of the resin layer 420 may be the same as or smaller than the area of the upper surface of the substrate 401. The resin layer 420 may be formed of a transparent material and may guide or diffuse light. The resin layer 420 may be used instead of a light guide plate, and it is convenient to adjust the refractive index and adjust the thickness.

Since the resin layer 420 is provided as a layer for guiding light through the resin material, it may be provided with a thinner thickness than that of glass and may be provided as a flexible plate. The resin layer 420 may emit the point light source emitted from the light emitting device 100 in the form of a line light source or a surface light source.

A bead (not shown) may be included in the resin layer 420, and the bead may diffuse and reflect incident light to increase the amount of light. The beads may be disposed in an amount of 0.01 to 0.3% based on the weight of the resin layer 420. The bead may be composed of any one selected from silicon, silica, glass bubble, polymethyl methacrylate (PMMA), urethane, Zn, Zr, Al2O3, and acryl, and the particle diameter of the beads may be in the range of about 1 µm to about 20 µm, but is not limited thereto.

Since the resin layer 420 is disposed on the light emitting device 100, it is possible to protect the light emitting device 100 and reduce loss of light emitted from the light emitting device 100. The light emitting device 100 may be buried under the resin layer 420.

The resin layer 420 may be in contact with the surface of the light emitting device 100 and may be in contact with the emission surface 81 of the light emitting device 100. A portion of the resin layer 420 may be disposed in the opening 417 of the reflective member 410. A portion of the resin layer 420 may be in contact with the upper surface of the substrate 401 through the opening 417 of the reflective member 410. Accordingly, a portion of the resin layer 420 may be in contact with the substrate 401, thereby fixing the reflective member 410 between the resin layer 420 and the substrate 401.

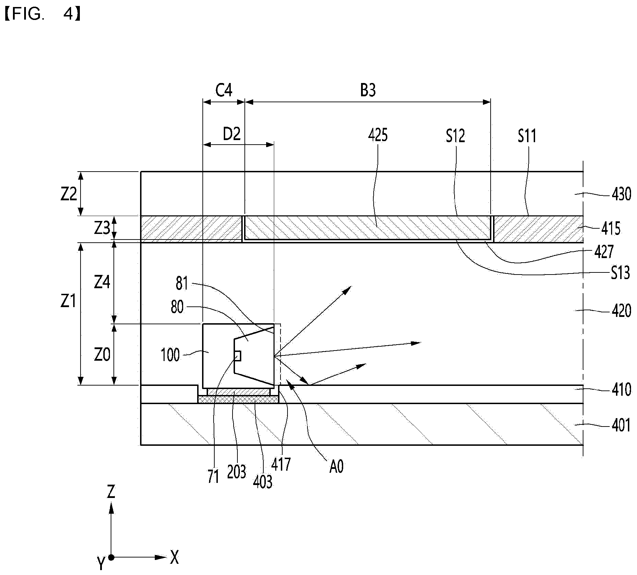

Referring to FIG. 4, the thickness Z1 of the resin layer 420 may be 1.8 mm or more, for example, in a range of 1.8 to 2.5 mm. When the thickness Z1 of the resin layer 420 is thicker than the above range, the luminous intensity may be lowered, and it may be difficult to provide a flexible module due to an increase in the module thickness. When the thickness Z1 of the resin layer 420 is smaller than the above range, it is difficult to provide a surface light source having a uniform luminous intensity.

The length of the resin layer 420 in the first direction X may be the same as the length of the substrate 401 in the first direction, and the width of the resin layer 420 in the second direction Y may be the same the width Y1 of the substrate 401 in the second direction. Accordingly, each side surface of the resin layer 420 may be disposed on the same plane as each side surface of the substrate 401. For example, the first and second side surfaces S1 and S2 of the substrate 401 may be disposed on the same vertical surface as both sides of the resin layer 420.

The resin layer 420 may be provided in a size to cover the plurality of light emitting devices 100 or may be connected to each other. The resin layer 420 may be divided into a size to cover each light emitting device 100, and may be divided into light emitting cells having each light emitting device 100 / each resin layer 420.

The upper surface of the resin layer 420 may have a first adhesive force. The upper surface of the resin layer 420 may have a first adhesive force and may be adhered to the light transmitting layer 415.

### Light transmitting layer 415

The light transmitting layer 415 may be an adhesive material such as silicone or epoxy, or may include a diffusion material. The diffusion material may include at least one of polyester (PET), poly methyl methacrylate (PMMA), or polycarbonate (PC). The light transmitting layer 415 may include an adhesive region that is adhered to the upper surface of the resin layer 420 and a non-adhesive region that is not adhered or spaced apart from the upper surface of the resin layer 420. The light transmitting layer 415 is disposed on 60% or more, for example, 80% or more, of the upper surface area of the resin layer 420, so that the diffusion layer 430 may be in close contact with the resin layer 420 or the lower diffusion layer (not shown).

### Light blocking portion 425

The light blocking portion 425 may face the upper surface of the resin layer 420. The light blocking portion 425 may overlap the light emitting device 100 in a vertical direction or a third direction Z. Each of the plurality of light blocking portions 425 may be vertically overlapped with each of the plurality of light emitting devices 100. The light blocking portion 425 may be disposed between the resin layer 420 and the diffusion layer 430. When the diffusion layer 430 is disposed in plurality, the light blocking portion 425 may be disposed between the plurality of diffusion layers.

The light blocking portion 425 may be disposed in the light transmitting layer 415. The light blocking portion 425 may pass through the light transmitting layer 415 and may be in contact with at least one of the resin layer 425 and the diffusion layer 430. The light blocking portion 425 may include a gap portion 427 spaced apart from the inner surface of the light transmitting layer 415 and/or the upper surface of the resin layer 420. The gap portion 427 may provide a refractive index different from that of the light blocking portion 425, thereby improving light diffusion efficiency. The lower surface S13 of the light blocking portion 425 may be spaced apart from or out of contact with the upper surface of the lower layer, for example, the upper surface of the resin layer 420. The gap portion 427 may be an air region or a vacuum region.

The interval B1 between the light blocking portions 425 may be smaller than the interval X1 between the light emitting devices 100. The light blocking portion 425 may be spaced apart from the outer surface of the resin layer 420. A plurality of the light blocking portions 425 may be arranged in the first direction. The plurality of light blocking portions 425 may have the same shape as each other. The light blocking portion 425 may be disposed on each light emitting device 100. Each of the light blocking units 425 may be disposed in a direction perpendicular to each of the light emitting devices 100 and in a peripheral region thereof.

The light blocking portion 425 may be disposed higher than the upper surface of the resin layer 420. The light blocking portion 425 may be 50% or more of the upper surface area of the light emitting device 100 on the light emitting device 100, or may be in the range of 50% to 200%. The light blocking portion 425 may be a region printed with a white material. The light blocking portion 425 may be printed using, for example, a reflective ink including any one of TiO2, Al2O3 CaCO3, BaSO4, and Silicon. The light blocking portion 425 reflects the light emitted through the emission surface of the light emitting device 100, thereby reducing the occurrence of hot spots on the light emitting device 100. The light blocking portion 425 may print a light blocking pattern using light blocking ink. The light blocking portion 425 may be formed by printing on the lower surface of the diffusion layer 430. The light blocking portion 425 is a material that does not block 100% of incident light, may have transmittance lower than reflectance, and may perform a function of blocking and diffusing light. The light blocking portion 425 may be formed in a single layer or multiple layers, and may have the same pattern shape or different pattern shapes. The light blocking portion 425 may have the same thickness. The thickness of the light blocking portion 425 may be formed to have a different thickness according to a region. As for the thickness of the light blocking portion 425, the center region may be the thickest and the edge region may be thinner than the center region. The thickness of the light blocking portion 425 may be proportional to the incident light intensity.

The size of the light blocking portion 425 may be arranged in a range of 50% or more, for example, 50% to 200%, of the upper surface area of the light emitting device 100 to block incident light. Accordingly, it is possible to reduce the problem of the light emitting device 100 being visible from the outside, and to reduce hot spots on the region of the light emitting device 100, thereby providing a uniform light distribution over the entire region.

As another example, the light blocking portion 425 may be an air region in a recess formed by an etching process on the upper surface of the resin layer 420, or may include a light blocking layer in which the light blocking material is disposed. The etching region may cover the emission surface of the light emitting device 100 by disposing the light emitting device 100 in a range of 50% to 200% of the upper surface area thereof, like the region of the light blocking portion. The light blocking portion 425 may be disposed in a hemispherical, elliptical, or circular shape with respect to the light emitting device 100.

Referring to FIGS. 2 and 4, the width C1 in the second direction Y of the region adjacent to the light emitting device 100 in the light blocking portion 425 is small and gradually increases toward the center of the light blocking portion 425, and the width (e.g., C3) in the second direction Y from the center may be maximally increased. The width in the second direction Y may gradually decrease as it moves away from the light emitting device 100 from the center of the light blocking portion 425. The maximum width C3 in the second direction Y at the center of the light blocking portion 425 is the largest, and the width in the second direction Y may be gradually narrowed as it moves away from the center of the light blocking portion 425 in the first direction X. In the light blocking portion 425, a region overlapping the light emitting device 100 in the vertical direction has a flat outer surface, and the flat outer surface has a width C1 in the second direction Y greater than the length D1 of the light emitting device 100 in the second direction. The second direction width C1 of the light blocking portion 425 is disposed to be 0.8 mm or more larger than the length D1 of the light emitting device 100, so that the light blocking portion 425 may be covered both sides of the light emitting device 100 and may prevent a hot spot caused by the light emitted from the light emitting device 100.

A maximum length B3 of the light blocking portion 425 in the first direction X may be equal to or smaller than a maximum width C3 of the second direction Y. The maximum width C3 may be 13 mm or more, for example, in the range of 13 mm to 17 mm. The maximum width C3 of the light blocking portion 425 in the second direction Y may vary according to the length D1 of the light emitting device 100 in the second direction Y. The maximum width C3 of the light blocking portion 425 in the second direction Y may be 50% or more of the length Y1 of the substrate 401 in the second direction Y, for example, in the range of 50% to 90%.

Here, the distance X1 between the light emitting devices 100 may be 25 mm or more, for example, in the range of 25 mm to 30 mm, and may vary depending on the characteristics of the light emitting devices 100. The light blocking portion 425 provides the maximum length B3 in the first direction X passing through the center of the light blocking portion 425 and the maximum width C3 in the second direction Y in the above range, it is possible to reduce hot spots on the light emitting device 100 and to improve light uniformity.

As shown in FIG. 4, the thickness Z3 of the light blocking portion 425 may be 0.1 times or less, for example, in a range of 0.05 times to 0.1 times the thickness Z1 of the resin layer 420. The thickness Z3 of the light blocking portion 425 may be 100 µm or more, for example, in the range of 100 to 200 µm. When the thickness Z3 of the light blocking portion 425 is smaller than the above range, there is a limit to reducing hot spots, and when the thickness Z3 is larger than the above range, light uniformity may be deteriorated. The distance Z4 between the upper surface of the light emitting device 100 and the lower surface of the light blocking portion 425 may be 0.4 mm or more, for example, in the range of 0.4 mm to 0.6 mm. The distance Z0 between the upper surface of the light emitting device 100 and the upper surface of the reflective member 410 may be 0.8 mm or more, for example, 0.8 mm to 1.4 mm. The region of the light blocking portion 425 may not vertically overlap with the region of the light transmitting layer 415.

The light blocking portion 425 may be provided on each of the light emitting devices 100 with a size or area sufficient to prevent a hot spot caused by the light emitted in the emission direction of the light emitting device 100. In addition, the light blocking portion 425 allows the light emitting device 100 to emit light in the side direction, that is, in the first direction, so that it covers a region capable of increasing the light blocking efficiency due to the light directed distribution of the light emitting device 100 and the reflection characteristics.

### Diffusion layer 430

The diffusion layer 430 may be disposed on the resin layer 420. A lower surface of the diffusion layer 430 may include a first region S11 in which the light transmitting layer 415 is disposed and a second region S12 in which the light blocking portion 425 is disposed. The diffusion layer 430 may have the light blocking portion 425 printed thereon, and may be fixed on the resin layer 420 through the light transmitting layer 415.

Here, when a lower diffusion layer (not shown) is disposed between the light transmitting layer 415 and the resin layer 420, the lower diffusion layer may adhere to the resin layer 420, for example, the upper surface of the resin layer 420 may be adhered to the lower diffusion layer by a first adhesive force having a micro ciliary. In this case, the diffusion layer 430 and/or the lower diffusion layer may be attached to the resin layer 420 by applying a predetermined pressure or pressure/heat.

The diffusion layer 430 may include at least one of a polyester (PET) film, a poly methyl methacrylate (PMMA) material, or a polycarbonate (PC) material. The diffusion layer 430 may be provided as a film made of a resin material such as silicone or epoxy. The diffusion layer 430 may include a single layer or multiple layers.

The thickness Z2 of the diffusion layer 430 is 25 micrometers or more, and may be, for example, in the range of 25 to 250 micrometers or in the range of 100 to 250 micrometers. The diffusion layer 430 may provide incident light having the above thickness range as a uniform surface light source.

The diffusion layer 430 and/or the lower diffusion layer may include at least one or two or more of a diffusion agent such as beads, a phosphor, and ink particles. The phosphor may include, for example, at least one of a red phosphor, an amber phosphor, a yellow phosphor, a green phosphor, and a white phosphor. The ink particles may include at least one of metal ink, UV ink, and curing ink. The size of the ink particles may be smaller than the size of the phosphor. The surface color of the ink particles may be any one of green, red, yellow, and blue. The ink types may be selectively applied among PVC (Poly vinyl chloride) ink, PC (Polycarbonate) ink, ABS (acrylonitrile butadiene styrene copolymer) ink, UV resin ink, epoxy ink, silicone ink, PP (polypropylene) ink, water-based ink, plastic ink, PMMA (poly methyl methacrylate) ink and PS (Polystyrene) ink. The ink particles may include at least one of metal ink, UV ink, and curing ink.

In the embodiment of the invention, light diffused by the resin layer 420 may be transmitted through the light transmitting layer 415 and may be emitted as a surface light source through the diffusion layer 430. In this case, the light blocking portion 425 may prevent a hot spot caused by the incident light.

In another example of the invention, a reflective layer or an upper substrate may be disposed on the resin layer 420. The layer of the reflective material or the upper substrate may face the upper surface of the resin layer 420, and the light emitting devices 100 are arranged in at least one row or column, and each emission surface 81 of the light emitting devices 100 may be disposed at the same distance as one side of the resin layer 420, and may emit light through one side of the resin layer 420.

Meanwhile, in the above description, it was described that the light emitting device emits light in a lateral direction of the resin layer, but the embodiment is not limited thereto. That is, the light emitting device may be connected to the substrate 410 in a top-view direction. Accordingly, the light emitting device may emit light in an upper direction of the resin layer 401.

Alternatively, referring to FIG. 11, a plurality of light emitting devices 100 may be disposed on the substrate 401. The plurality of light emitting devices 100 may be a top-view type electrically connected to the substrate 401. The plurality of light emitting devices 100 may be disposed at set intervals on the substrate 401. For example, the plurality of light emitting devices 100 may be disposed at an equal interval in the first direction. In addition, the plurality of light emitting devices 100 may be disposed at an equal interval in the second direction.

Accordingly, the lighting module 400 including the plurality of light emitting devices 100 can emit light as a surface light source. The lighting module 400 can emit light in an open upper direction of the housing 300.

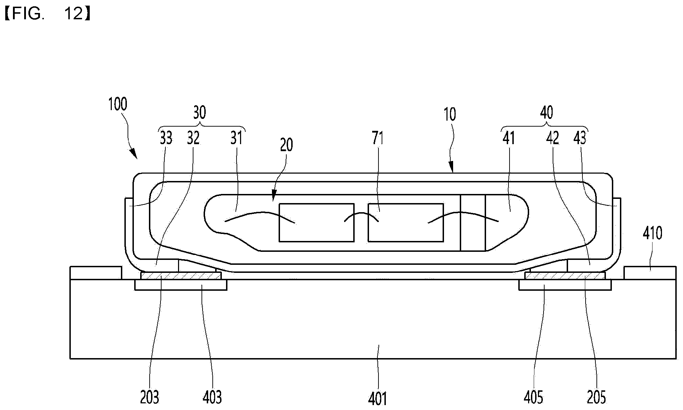

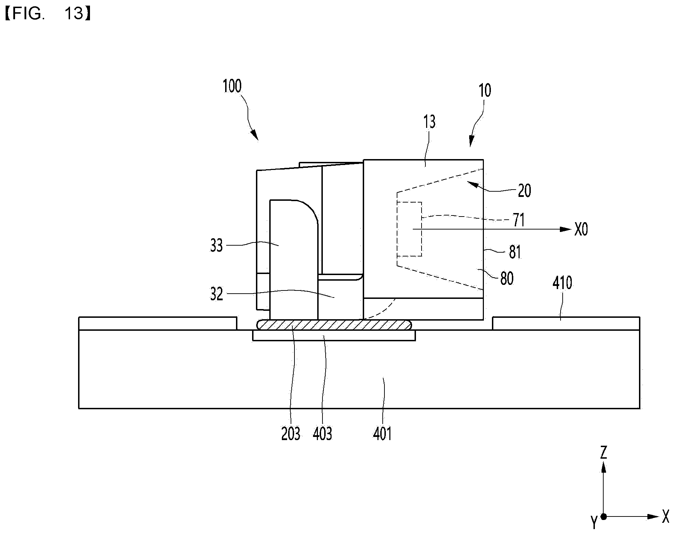

FIG. 12 is a front view showing a light emitting device on a substrate in a lighting module according to an embodiment, and FIG. 13 is a side view of the light emitting device of FIG. 12.

Referring to FIGS. 12 and 13, the light emitting device 100 includes a body 10 having a cavity 20, a plurality of lead frames 30 and 40 in the cavity 20, and a light emitting chip 71 disposed on at least one of the plurality of lead frames 30 and 40. The light emitting device 100 may be implemented as a side emission type package.

The body 10 may include a cavity 20 in which the lead frames 30 and 40 are exposed at the bottom. The plurality of lead frames 30 and 40 are separated into, for example, a first lead frame 30 and a second lead frame 40 and coupled to the body 10.

The body 10 may be formed of an insulating material. The body 10 may be formed of a reflective material. The body 10 may be formed of a material having a reflectance higher than a transmittance for a wavelength emitted from the light emitting chip, for example, a material having a reflectance of 70% or more. When the reflectivity is 70% or more, the body 10 may be defined as a non-transmissive material or a reflective material. The body 10 may be formed of a resin-based insulating material, for example, a resin material such as Polyphthalamide (PPA). The body 10 may be formed of a silicone-based, epoxy-based, or thermosetting resin including a plastic material, or a high heat and light resistance material. The body 10 includes a white-based resin. In the body 10, an acid anhydride, an antioxidant, a mold release material, a light reflector, an inorganic filler, a curing catalyst, a light stabilizer, a lubricant, and titanium dioxide may be selectively added. The body 10 may be molded by at least one selected from the group consisting of an epoxy resin, a modified epoxy resin, a silicone resin, a modified silicone resin, an acrylic resin, and a urethane resin. For example, an epoxy resin composed of triglycidyl isocyanurate, hydrogenated bisphenol A diglycidyl ether, etc., and an acid anhydride composed of hexahydrophthalic anhydride, 3-methylhexahydrophthalic anhydride, 4-methylhexahydrophthalic anhydride, etc., DBU (1,8-Diazabicyclo(5,4,0)undecene-7) as a curing accelerator, ethylene glycol as a cocatalyst, titanium oxide pigment, and glass fiber are added to the epoxy resin, and a B-stage is partially cured by heating, but this is not limited thereto. The body 10 may appropriately mix at least one selected from the group consisting of a dispersant, a pigment, a fluorescent material, a reflective material, a light blocking material, a light stabilizer, and a lubricant into a thermosetting resin.

The body 10 may include a reflective material, for example, a resin material to which a metal oxide is added, and the metal oxide may include at least one of TiO2, SiO2, and Al2O3. The body 10 may effectively reflect incident light. As another example, the body 10 may be formed of a translucent resin material or a resin material having a phosphor for converting the wavelength of incident light. The bottom of the body 10 may be a side surface corresponding to the substrate 401.

The first lead frame 30 includes a first lead part 31 disposed on the bottom of the cavity 20, a first bonding part 32 extending outside the body 10, and a first heat dissipation part 33. The first bonding part 32 is bent from the first lead part 31 in the body 10 and protrudes outside the body, and the first heat dissipation part 33 may be bent from the first bonding part 32.

The second lead frame 40 includes a second lead part 41 disposed on the bottom of the cavity 20, a second bonding part 42 and a second heat dissipation part 43 disposed on an outer region of the body 10. The second bonding part 42 may be bent from the second lead part 41 in the body 10, and the second heat dissipation part 43 may be bent from the second bonding part 42.

Here, the light emitting chip 71 may be disposed on the first lead part 31 of the first lead frame 30, for example, and connected to the first and second lead parts 31 and 41 with a wire, or may be connected to the first lead part 31 with an adhesive and connected to the second lead part 41 with a wire. The light emitting chip 71 may be a horizontal chip, a vertical chip, or a chip having a via structure. The light emitting chip 71 may be mounted in a flip chip method. The light emitting chip 71 may selectively emit light within a wavelength range of ultraviolet to visible light. The light emitting chip 71 may emit, for example, ultraviolet or blue peak wavelength. The light emitting chip 71 may include at least one of a group II-VI compound and a group III-V compound. The light emitting chip 71 may be formed of, for example, a compound selected from the group consisting of GaN, AlGaN, InGaN, AlInGaN, GaP, AIN, GaAs, AlGaAs, InP, and mixtures thereof.

One or a plurality of the light emitting chips 71 may be disposed in the cavity 20 and emit light with the greatest intensity in the direction of the central axis X0.

One or a plurality of light emitting chips disposed in the cavity 20 of the light emitting device 100 according to the embodiment may be disposed. The light emitting chip may be selected from, for example, a red LED chip, a blue LED chip, a green LED chip, and a yellow green LED chip.

A molding member 80 is disposed in the cavity 20 of the body 11, and the molding member 80 includes a light-transmitting resin such as silicone or epoxy, and may be formed in a single layer or in multiple layers. A phosphor for changing the wavelength of the emitted light may be included on the molding member 80 or the light emitting chip 71, and the phosphor excites a portion of the light emitted from the light emitting chip 71 to generate a different wavelength. emitted as light. The phosphor may be selectively formed from quantum dots, YAG, TAG, silicate, nitride, and oxygen-nitride-based materials. The phosphor may include at least one of a red phosphor, a yellow phosphor, and a green phosphor, but is not limited thereto. The emission surface 81 of the molding member 80 may be formed in a flat shape, a concave shape, a convex shape, or the like, but is not limited thereto. As another example, a light-transmitting film having a phosphor may be disposed on the cavity 20, but the present disclosure is not limited thereto.

A lens may be further formed on the upper portion of the body 10, and the lens may include a structure of a concave and/or convex lens, and control the light distribution of the light emitted by the light emitting device 100.

A semiconductor device such as a light receiving device and a protection device may be mounted on the body 10 or any one of the lead frames, and the protection device may be implemented as a thyristor, a Zener diode, or a TVS (Transient voltage suppression), and the Zener diode protects the light emitting chip from electrostatic discharge (ESD).

At least one or a plurality of light emitting devices 100 are disposed on the substrate 401, and a reflective member 410 is disposed around a lower portion of the light emitting device 100. The first and second lead portions 33 and 43 of the light emitting device 100 are bonded to the pads 403 and 405 of the substrate 401 with solder or conductive tape as conductive adhesive members 203 and 205.

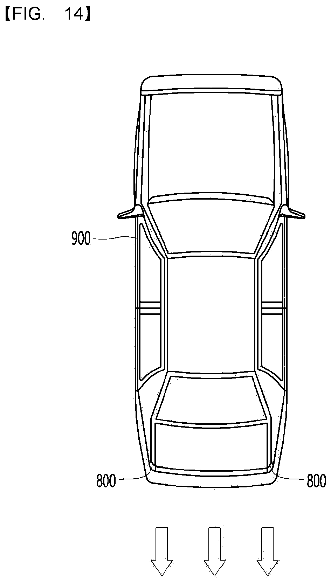

FIG. 14 is a plan view of a vehicle to which the vehicle lamp of FIG. 9 is applied.

Referring to FIG. 14, a vehicle lighting may include a first lamp unit 812, a second lamp unit 814, a third lamp unit 816, and a housing 810. Here, each lamp unit may be a light source for a role such as a head lamp, a side mirror light, a side maker light, a fog lamp, a turn signal light, a tail lamp, a brake light, a daytime running light, a rear combination lamp, a backup lamp, etc., but is not limited thereto.

The housing 810 accommodates the first to third lamp units 812, 814, and 816, and may be made of a light-transmitting material. In this case, the housing 810 may have a curve according to the design of the vehicle body, and the first to third lamp units 812, 814, and 816 implement a surface light source that may have a curved surface according to the shape of the housing 810.

Features, structures, effects, etc. described in the above embodiments are included in at least one embodiment of the invention, and are not necessarily limited to only one embodiment. Furthermore, features, structures, effects, etc. illustrated in each embodiment may be combined or modified for other embodiments by those of ordinary skill in the art to which the embodiments belong. Accordingly, the contents related to such combinations and modifications should be interpreted as being included in the scope of the invention.

In addition, although the embodiment has been described above, it is only an example and does not limit the invention, and those of ordinary skill in the art to which the invention pertains are exemplified above in a range that does not depart from the essential characteristics of the present embodiment. It may be seen that various modifications and applications that have not been made are possible. For example, each component specifically shown in the embodiment may be implemented by modification. And the differences related to these modifications and applications should be construed as being included in the scope of the invention defined in the appended claims.

## Claims

1. A resin composition comprising:
an oligomer, a monomer, a photoinitiator, and an additive,
wherein the oligomer is contained in an amount of 10 wt% to 25 wt% based on a total weight of the resin composition,
wherein the monomer is contained in an amount of 60 wt% to 70 wt% based on the total weight of the resin composition,
wherein the photoinitiator is contained in an amount of 0.5 wt% to 1.2 wt% based on the total weight of the resin composition,
wherein the additive includes a first additive comprising a radical removing agent and a second additive comprising a peroxide decomposition agent,
wherein the photoinitiator includes phosphorus (P),
wherein the second additive includes phosphorus (P), and
wherein a weight % of the photoinitiator is greater than a weight % of each of the first additive and the second additive.

2. The resin composition of claim 1, wherein the additive is contained in an amount of 0.5 wt% to 1.6 wt% based on the total weight of the resin composition.

3. The resin composition of claim 2, wherein the weight % of the first additive is greater than the weight % of the second additive.

4. The resin composition of claim 3, wherein the first additive is contained in an amount of 0.3 wt% to 0.9 wt% based on the total weight of the resin composition, and
wherein the second additive is contained in an amount of 0.2 wt% to 0.7 wt% based on the total weight of the resin composition.

5. The resin composition of claim 4, wherein the oligomer is a first oligomer including an urethane acrylate of a tetramethylene glycol series; and a second oligomer including an urethane acrylate of an ethylene glycol series,
wherein the first oligomer is contained in an amount of 8 wt% to 20 wt% based on the total weight of the resin composition, and
wherein the second oligomer is contained in an amount of 2 wt% to 5 wt% based on the total weight of the resin composition.

6. The resin composition of claim 5, wherein the monomer includes a first monomer including IBOA (Isobonyl acrylate), a second monomer including at least one of EHA (2-Ethylhexyl acrylate) and LA (Lauryl Acrylate), a third monomer including at least one of CA (Caprolactone acrylate) and 2-(2-Ethoxyethoxy)ethyl acrylate, and a fourth monomer including at least one of GMA (Glycidyl methacrylate) and 3,4-epoxycyclohexylmethyl methacrylate,
wherein the first monomer is contained in an amount of 40 wt% to 50 wt% based on the total weight of the resin composition,
wherein the second monomer is contained in an amount of 3 wt% to 18 wt% based on the total weight of the resin composition,
wherein the third monomer is contained in an amount of 15 wt% to 30 wt% based on the total weight of the resin composition, and
wherein the fourth monomer is contained in an amount of 7 wt% to 14 wt% based on the total weight of the resin composition.

7. The resin composition of claim 1, wherein a decomposition temperature of the photoinitiator is 50°C to 250°C.

8. The resin composition of claim 1, wherein the photoinitiator absorbs light in a wavelength band of 50 nm to 400 nm.

9. A resin composition comprising:
an oligomer, a monomer, a photoinitiator, a first additive, and a second additive,
wherein the oligomer is contained in an amount of 10 wt% to 25 wt% based on a total weight of the resin composition,
wherein the monomer is contained in an amount of 60 wt% to 70 wt% based on the total weight of the resin composition,
wherein the photoinitiator is contained in an amount of 0.5 wt% to 1.2 wt% based on the total weight of the resin composition,
wherein a sum of a wt% of the first additive and a wt% of the second additive is contained in an amount of 0.5 wt% to 1.6 wt% based on the total weight of the resin composition,
wherein the first additive includes a radical removing agent,
wherein the second additive includes a peroxide decomposition agent,
wherein the photoinitiator includes phosphorus (P),
wherein the second additive includes phosphorus (P), and
wherein a ³¹P-NMR peak area of the second additive is 10% to 90% of a ³¹P-NMR peak area of the photoinitiator.

10. A lighting device comprising:
a substrate;
a light emitting device disposed on the substrate; and
a resin layer disposed around the light emitting device on the substrate, and
wherein the resin layer includes a resin composition of any one of claims 1 to 9.
